# EUROPÄISCHE PATENTSCHRIFT

(11) **EP 3 670 059 B1**
(45) Veröffentlichungstag und Bekanntmachung des Hinweises auf die Patenterteilung: **29.09.2021**
(21) Anmeldenummer: 19215481.3
(22) Anmeldetag: 12.12.2019
(51) Int. Cl.: B23K 10/00, B23K 10/02, B23K 26/36, B23K 26/38, B23K 26/362, B23K 26/53, B23K 26/0622, B23K 26/08, B23K 26/04

(54) **VORRICHTUNG UND VERFAHREN ZUM GEREGELTEN BEARBEITEN EINES WERKSTÜCKES MIT EINER BEARBEITUNGSSTRAHLUNG**
DEVICE AND METHOD FOR REGULATED PROCESSING OF A WORKPIECE BY MEANS OF A PROCESSING LASER
DISPOSITIF ET PROCÉDÉ D'USINAGE RÉGULÉ D'UNE PIÈCE À L'AIDE D'UN RAYONNEMENT D'USINAGE

(30) Priorität: 20.12.2018 DE 102018133083
(43) Veröffentlichungstag der Anmeldung: 24.06.2020
(73) Patentinhaber: Carl Zeiss Jena GmbH, 07745 Jena (DE)
(72) Erfinder: KÖHLER, Thomas, 07743 Jena (DE); SCHINDLER, Christian, 99423 Weimar (DE); SCHEIBE, Hannes, 07745 Jena (DE); ROTH, Eckhard, 07751 Großlöbichau (DE)
(74) Vertreter: Schaller, Renate

(56) Entgegenhaltungen:
- EP-A1- 2 202 026
- US-A1- 2008 204 748

## Beschreibung

Die Erfindung betrifft eine Vorrichtung und ein Verfahren zum Bearbeiten eines Werkstückes mittels Bearbeitungsstrahlung, wie es gattungsgemäß aus der EP 2 202 026 A1 bekannt ist.

Neben mechanischen Verfahren ist es bekannt, mittels Bearbeitungsstrahlung, hier sind ein oder mehrere, gleiche oder unterschiedliche Bearbeitungsstrahlen gemeint, Material zu trennen, abzutragen oder zu modifizieren, um die Kontur oder die Oberfläche eines Werkstückes zu bearbeiten. Nachteilig an einer Bearbeitung mittels einer Bearbeitungsstrahlung ist das zu einer mechanischen Bearbeitung vergleichsweise undefinierte Bearbeitungsergebnis. Das hat zum einen seine Ursache in Parameterschwankungen des Energieeintrages, der z.B. in Fokuslagenschwankungen und Leistungsschwankungen des Bearbeitungsstrahls, aber auch in Materialinhomogenitäten des Werkstückes liegen kann. Es gibt eine Vielzahl von technischen Lösungen im Stand der Technik, bei denen die für den Energieeintrag bestimmenden Parameter überwacht und nachgeregelt werden, um deren Schwankungsbreite zu minimieren. Zum Beispiel ist es bekannt, die Fokuslage zu überwachen und nachzuregeln oder über einen ausgekoppelten Referenzstrahl die Intensitätsschwankung des Bearbeitungsstrahls zu erfassen, um die Leistungsabgabe der Strahlungsquelle nachzuregeln. Bei derartigen Lösungen bleibt jedoch der Einfluss, den das Werkstück selbst auf das Bearbeitungsergebnis hat, völlig außer Betracht.

Aus der vorgenannten EP 2 202 026 A1 sind eine Laserbearbeitungsvorrichtung und ein Verfahren zur Herstellung von Dünnfilm-Solarzellen beschrieben, bei dem entlang von zueinander parallelen Linien Material von einem Werkstück, hier eine Filmschicht von einem Substrat, abgetragen wird, wobei sich Nuten ausbilden. Es wurde als Problem erkannt, dass z.B. durch Schwankungen der Laserintensität, durch Schwankung der Filmschichtdicke und durch die Welligkeit des Substrates die Qualität der Nuten beeinträchtigt wird.

Gegenüber anderen in der vorgenannten EP 2 202 026 A1 angegebenen Lösungen des Standes der Technik, bei denen das Werkstück nach der Bearbeitung zu einem Messplatz und anschließend, im Falle einer notwendigen Nacharbeit, zurück zum Bearbeitungsplatz transportiert wird, wo es die Bearbeitung eines nächsten Werkstückes blockiert, was zu einer Verringerung des Durchsatzes führt, wird hier das Werkstück zeitgleich bearbeitet und vermessen.

Konkret wird eine Vorrichtung mit einer Bearbeitungslaserstrahleinrichtung, einer optischen Inspektionseinrichtung und einer Welligkeitsmesseinrichtung vorgeschlagen, bei der die genannten Einrichtungen zueinander eine feste räumliche Anordnung aufweisen und zu einem Werkstücktisch, bezogen auf ein kartesisches Koordinatensystem, in y-Richtung verfahrbar und in x-Richtung schrittweise um den Abstand der zu erzeugenden Nuten, die in y-Richtung verlaufen, verstellbar sind.

Jeweils nachdem der Werkstücktisch einmal entlang der y-Richtung in einem Richtungssinn bewegt wurde, wobei das Werkstück mit einem Laserstrahl, von der Bearbeitungslaserstrahleinrichtung kommend, bestrahlt und eine Nut gebildet wurde, wird der Werkstücktisch, bevor der Laserstrahl erneut entlang der y-Richtung im entgegengesetzten Richtungssinn bewegt wird, um den vorgegebenen Abstand in x-Richtung versetzt, so dass mit dem Laserstrahl geradlinige, parallele Nuten in regelmäßigen Abständen zueinander entstehen. Die optische Achse des Objektives der optischen Inspektionseinrichtung ist der optischen Achse der Bearbeitungslaserstrahleinrichtung um den vorgegebenen Abstand oder ein Vielfaches hiervon in x-Richtung nachgeordnet angeordnet, sodass zeitgleich mit der Herstellung einer Nut eine bereits gefertigte Nut inspiziert wird, wobei insbesondere die Tiefe, Breite oder Rauheit der Nut erfasst werden. Die Welligkeitsmesseinrichtung umfasst eine Hilfslichtquelle und einen Hilfsfotodetektor. Der von der Hilfslichtquelle ausgesandte Messstrahl wird auf einen Punkt gerichtet, der in x-Richtung der sich in Herstellung befindenden Nut um den vorgegebenen Abstand oder ein Vielfaches hiervon vorgeordnet ist, sodass zeitgleich mit der Herstellung und der Inspektion der Nut die Welligkeit der Oberfläche des Werkstückes erfasst wird. Da das Werkstück durch dieselbe Bewegung des Werkstücktisches gegenüber den Auftreffpunkten des Bearbeitungslaserstrahls, des Messstrahls der Welligkeitsmesseinrichtung und des Prüfstrahls der Inspektionseinrichtung bewegt wird, haben die Auftreffpunkte eine feste Raumlage zueinander und können als zueinander korrelierende Auftreffpunkte einander zugeordnet werden. Im Vergleich zu Systemen, bei denen ein Vermessen und Prüfen eines Werkstückes anderen Orts stattfindet als das Bearbeiten, ist hier die Gesamtprozessdauer kürzer und die Genauigkeit der Prüfung höher. Auch kann bei der Feststellung von Fehlern während der Inspektion die betreffende Nut lediglich durch einen definierten Rückversatz erneut unter den Bearbeitungslaserstrahl versetzt werden, um nachbehandelt zu werden. Außerdem kann das Ergebnis der Welligkeitsmessung genutzt werden, um Bearbeitungsparameter zu regeln, z.B. um über eine Verstellung der Kondensorlinse der Bearbeitungslaserstrahleinrichtung die Fokuslage des Bearbeitungslaserstrahls zu verändern.

Nachteilig an einem Verfahren gemäß der vorgenannten EP 2 202 026 A1 ist insbesondere, dass die kontinuierlich schrittweise Verstellung des Werkstückes in einen Richtungssinn in x-Richtung unterbrochen werden muss und das Werkstück in den entgegengesetzten Richtungssinn zurückversetzt werden muss, um eine geprüfte Nut bei Bedarf einer Nacharbeit zuzuführen.

Auch ist es nachteilig, dass die Relativgeschwindigkeit zwischen dem Bearbeitungslaserstrahl und dem Werkstück durch die Bewegungsumkehr, jeweils in den Umkehrpunkten, nicht bis zum Ende einer Nut konstant ist, wenn die Umkehrpunkte nicht außerhalb des Werkstückes gelegt werden.

Es ist die Aufgabe der Erfindung, eine Vorrichtung und ein Verfahren zu finden, bei denen mit einer hohen zeitlichen Effizienz mehrere Werkstücke zeitgleich mit einer hohen Genauigkeit bearbeitet werden können.

Die Aufgabe wird für eine Vorrichtung mit einem Werkstückträger, der wenigstens eine Werkstückaufnahme, zur Aufnahme wenigstens eines Werkstückes aufweist, wenigstens einer Bearbeitungseinheit mit einer Bearbeitungsstrahlquelle, die einen Bearbeitungsstrahl auf das in der wenigstens einen Werkstückaufnahme aufgenommene Werkstück richtet, wenigstens einer Prüfeinheit mit einer Prüfstrahlquelle, die einen Prüfstrahl auf das in der wenigstens einen Werkstückaufnahme aufgenommene Werkstück richtet, und einem Detektor, der einen transmittierten, reflektierten oder gestreuten Prüfstrahlanteil des Prüfstrahles detektiert, und wenigstens einem Linearmotor, mit dem die wenigstens eine Bearbeitungseinheit und die wenigstens eine Prüfeinheit relativ zum Werkstückträger beweglich sind, wobei das in der wenigstens einen Werkstückaufnahme positionierte Werkstück entlang nebeneinander verlaufender Scanlinien durch den Bearbeitungsstrahl und den Prüfstrahl nachlaufend abgescannt wird und das Werkstück entlang der Scanlinien bearbeitet und geprüft wird, durch folgende Merkmale gelöst:
- Es ist ein Motor vorhanden und der Werkstückträger weist eine umlaufende Drehachse auf, die zur Erzeugung einer Drehbewegung des Werkstückträgers in einer Drehrichtung mit dem Motor verbunden ist.
- Die wenigstens eine Bearbeitungseinheit und die wenigstens eine Prüfeinheit sind gegenüber der Drehachse um einen Winkelabstand zueinander versetzt jeweils radial zur Drehachse justierbar angeordnet und mit dem wenigstens einen Linearmotor verbunden, um Translationsbewegungen der Bearbeitungseinheit und der Prüfeinheit gegenüber dem Werkstückträger in zwei den Winkelabstand miteinander einschließende radiale translatorische Richtungen zu erzeugen. Dadurch beschreiben, bei gleichzeitiger Ansteuerung des Motors und des wenigstens einen Linearmotors, der Bearbeitungsstrahl und der Prüfstrahl, um den Winkelabstand zueinander versetzt, relativ zum Werkstückträger eine selbe spiralförmige Bewegungsbahn mit einer Vielzahl von Windungen.
- Die wenigstens eine Werkstückaufnahme ist zu der Drehachse in einem Abstand entfernt angeordnet, sodass die wenigstens eine Werkstückaufnahme oder ein darin positioniertes Werkstück von Teilabschnitten der Windungen überdeckt wird, die jeweils eine der Scanlinien darstellen.
- Es ist eine Steuer- und Recheneinheit vorhanden, die mit der wenigstens einen Prüfeinheit, mit der wenigstens einen Bearbeitungseinheit, dem Motor und dem wenigstens einen Linearmotor in Verbindung steht, um in Abhängigkeit von aus dem detektierten Prüfstrahlanteil abgeleiteten Prüfergebnissen wenigstens einen Verfahrensparameter der Vorrichtung zu ändern.

Vorteilhaft ist eine Summe von mehreren Bearbeitungseinheiten vorhanden, die einen Kreis um die Drehachse bildend angeordnet sind, wobei die Summe größer als die Anzahl der Werkstückaufnahmen ist.

Auch ist es vorteilhaft, wenn wenigstens eine erste Kippeinheit vorhanden ist, die mit der wenigstens einen Bearbeitungseinheit verbunden ist, und wenigstens eine zweite Kippeinheit vorhanden ist, die mit der wenigstens einen Prüfeinheit verbunden ist, womit die Ausrichtung des Bearbeitungsstrahles und des Prüfstrahles zu einer Oberfläche des in der mindestens einen Werkstückaufnahme positionierten Werkstückes veränderbar ist.

Die Bearbeitungsstrahlquelle der mindestens einen Bearbeitungseinheit ist vorteilhaft ein Laser oder eine Plasma-Strahlquelle.

Die Aufgabe wird für ein Verfahren, bei dem wenigstens ein Werkstück in einer Werkstückaufnahme auf einem Werkstückträger positioniert wird und entlang nebeneinander verlaufender Scanlinien mit einem Bearbeitungsstrahl mehrfach jeweils in einem Scanzyklus abgetastet wird, wobei das Werkstück bearbeitet wird, und während der Scanzyklen mit einem dem Bearbeitungsstrahl nachlaufenden Prüfstrahl abgetastet wird, wobei Messungen durchgeführt werden, bei denen aus transmittierten, reflektierten oder gestreuten Prüfstrahlanteilen des jeweils in ausgedehnten Prüfpunkten auf eines der Werkstücke auftreffenden Prüfstrahls ortsbezogene Prüfergebnisse abgeleitet werden, aus denen Rückschlüsse auf die Auswirkung der lokalen Einwirkung des Bearbeitungsstrahls auf das jeweilige Werkstück gezogen werden, durch folgende Merkmale gelöst:
- Das Werkstück führt um eine außerhalb des Werkstückes liegende Drehachse des Werkstückträgers eine Drehbewegung in einer Drehrichtung mit einer Drehgeschwindigkeit aus.
- Der Bearbeitungsstrahl und der Prüfstrahl führen zeitgleich mit einer gleichen Vorschubgeschwindigkeit in zwei einen Winkelabstand miteinander einschließende translatorische Richtungen radial zur Drehachse Translationsbewegungen aus.
- Dadurch beschreiben der Bearbeitungsstrahl und der Prüfstrahl jeweils durch die Überlagerung der Drehbewegung mit einer der Translationsbewegungen über mehrere Umdrehungen des Werkstückträgers eine selbe spiralförmige Bewegungsbahn mit mehreren Windungen um die Drehachse relativ zu dem Werkzeugträger, wobei jeweils ein Teilabschnitt einer der Windungen, die die Werkstückaufnahme überdecken, eine der Scanlinien bildet.
- Die Prüfergebnisse werden jeweils als auf einen der Prüfpunkte ortsbezogene Istwerte einer Steuer- und Recheneinheit zugeführt, wo sie abgespeicherten, auf das Werkstück ortsbezogenen Sollwerten zugeordnet und mit diesen verglichen werden.
- Bei einer Abweichung eines der Sollwerte von dem zugeordneten Istwert wird wenigstens ein Verfahrensparameter geändert, wenn der Bearbeitungsstrahl nachfolgend in einem Auftreffpunkt innerhalb des betreffenden Prüfpunktes auf das Werkstück auftrifft, an dem zuvor die die Änderung begründenden ortsbezogenen Istwerte gewonnen wurden.

Es ist von Vorteil, wenn die Prüfpunkte jeweils eine größere Ausdehnung aufweisen als die Auftreffpunkte und die Änderung der Verfahrensparameter innerhalb des gleichen Scanzyklus erfolgt.

Alternativ kann die Änderung der Verfahrensparameter vorteilhaft innerhalb eines nachfolgenden Scanzyklus erfolgen.

Auch ist es günstig, die Drehgeschwindigkeit in Abhängigkeit vom radialen Abstand des Auftreffpunktes des Bearbeitungsstrahls zu steuern, um eine konstante Einwirkdauer des Bearbeitungsstrahls entlang der Scanlinien zu erreichen.

Die Steigung der spiralförmigen Bewegungsbahn und damit der Abstand der Scanlinien wird bevorzugt über die Einstellung des Verhältnisses zwischen der Drehgeschwindigkeit und der Vorschubgeschwindigkeit eingestellt.

Auch ist es vorteilhaft, wenn die Drehrichtung während des Verfahrens umgekehrt wird.

Es ist günstig, wenn das Werkstück während einer Umdrehung des Werkstückträgers mit mehr als einem Bearbeitungsstrahl bearbeitet wird und / oder wenn das Werkstück während einer Umdrehung des Werkstückträgers mit mehr als einem Prüfstrahl geprüft wird.

Auch können vorteilhaft mehrere Werkstücke in denselben Scanzyklen bearbeitet und geprüft werden, indem sie für einen gleichen Bearbeitungszeitraum auf dem Werkstückträger positioniert werden.

Die Erfindung soll nachfolgend anhand von Ausführungsbeispielen mit Hilfe von Zeichnungen näher erläutert werden. Hierzu zeigen:
- Fig. 1a: eine Prinzipskizze für eine Ausführung einer Vorrichtung mit nur einer Bearbeitungseinheit und einer Prüfeinheit in Draufsicht,
- Fig. 1b: eine Seitenansicht der Ausführung nach Fig. 1a als Prinzipskizze,
- Fig. 1c: eine schematische Darstellung der Bewegungsbahn relativ zu einem Werkstück und
- Fig. 2: eine Prinzipskizze für eine Ausführung einer Vorrichtung mit drei Bearbeitungseinheiten und einer Prüfeinheit in Draufsicht.

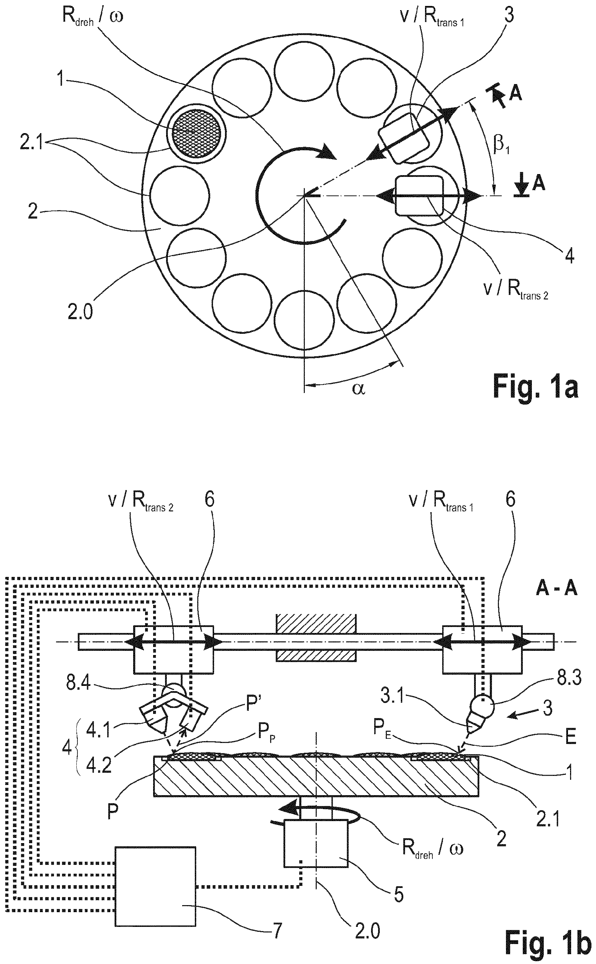

Eine erfindungsgemäße Vorrichtung enthält im Wesentlichen, wie in den **Fig. 1a** und **1b** dargestellt, einen Werkstückträger 2, wenigstens eine Bearbeitungseinheit 3, wenigstens eine Prüfeinheit 4, einen Motor 5, wenigstens einen Linearmotor 6 und eine Steuer- und Recheneinheit 7.

Der Werkstückträger 2 weist eine umlaufende Drehachse 2.0 auf, die mit dem Motor 5 verbunden ist, und ist in einer Drehrichtung R_{dreh}, die auch während des Verfahrens umkehrbar ist, mit einer regelbaren Drehgeschwindigkeit ω rotierbar. Bevorzugt ist der Werkstückträger 2 in Form eines Drehtellers bzw. einer Drehscheibe mit zwei Stirnseiten ausgebildet. Er weist wenigstens eine Werkstückaufnahme 2.1 auf einer der Stirnseiten auf, in der jeweils ein Werkstück 1 in einer definierten Raumlage zu einem durch den Werkstückträger 2 definierten Koordinatensystem positioniert wird. Damit kann jedem Punkt auf der Oberfläche eines der Werkstücke 1 ein auf den Werkstückträger 2 bezogener Ort im Raum und umgekehrt zugeordnet werden. Bevorzugt sind mehrere Werkstückaufnahmen 2.1 auf einer oder auch auf beiden der Stirnseiten auf dem Werkstückträger 2 angeordnet, die bevorzugt alle, bezogen auf die Drehachse 2.0, einen gleichen Abstand a und eine gleiche Ausrichtung aufweisen, sodass darin positionierte Werkstücke 1 eine gleiche Raumlage bezogen auf den Werkstückträger 2, lediglich um einen Drehwinkel α zueinander versetzt, aufweisen. Dabei ist der minimal mögliche Drehwinkel α zwischen den jeweils benachbarten Werkstückaufnahmen 2.1 durch die Größe der Werkstücke 1 und damit der Werkstückaufnahmen 2.1 bestimmt.

Entsprechend der Anzahl der Werkstückaufnahmen 2.1 können zeitgleich mehrere Werkstücke 1 auf dem Werkstückträger 2 positioniert werden, die dann gemeinsam in mehreren Scanzyklen gleichermaßen bearbeitet werden. Unter dem Bearbeiten soll jede mit einem Bearbeitungsstrahl mögliche Veränderung am Werkstück 1 verstanden werden, wie Abtragen, Schneiden oder Modifizieren.

Grundsätzlich können durch eine differenzierte Ansteuerung der wenigstens einen Bearbeitungseinheit 3, die nachfolgend erläutert wird, innerhalb der Scanzyklen auch unterschiedliche Werkstücke 1 oder gleiche Werkstücke 1 mit einem unterschiedlichen Bearbeitungsregime bearbeitet werden, indem die Bearbeitungseinheit 3 differenziert angesteuert wird, was aber in den nachfolgenden Erläuterungen der Einfachheit halber außer Betracht bleiben soll. Mehrere Bearbeitungseinheiten 3 können zeitgleich Werkstücke 1, die auf einer der Stirnseiten oder auch auf beiden Stirnseiten in den Werkstückaufnahmen 2.1 angeordnet sind, bearbeiten. Auch können mehrere Prüfeinheiten 4 vorhanden sein, die entweder auf eine der Stirnseiten oder auch auf beide Stirnseiten gerichtet sind.

Darüber hinaus erfolgt die nachfolgende Beschreibung der Einfachheit halber anhand von nur einer Bearbeitungseinheit 3 und nur einer Prüfeinheit 4. Sie kann ohne Weiteres auf eine Vorrichtung mit mehreren Bearbeitungseinheiten 3 und / oder mehreren Prüfeinheiten 4 übertragen werden.

Die Bearbeitungseinheit 3 weist eine Bearbeitungsstrahlquelle 3.1 auf, die einen Bearbeitungsstrahl E aussendet und direkt oder über eine Abstrahleinheit mit einer strahlformenden Optik auf die Werkstückaufnahme 2.1 bzw. auf das hier positionierte Werkstück 1 richtet. Als Bearbeitungsstrahlquellen 3.1 kommen z.B. Laser, insbesondere Ultrakurzpulslaser, und Plasmastrahlquellen, zur Anwendung. Neben den allgemeingültigen Vorteilen eines Lasers, insbesondere eines Kurzpulslasers, nämlich dass er kontaktlos und als verschleißfreies Werkzeug nur eine eng begrenzte Wirkzone beeinflusst und angrenzendes Material höchstens gering thermisch beeinflusst, kommen in Verbindung mit einer erfindungsgemäßen Vorrichtung insbesondere die Vorteile zur Wirkung, dass ein Energieeintrag durch den Laser in das Material über Größenordnungen und mit der Änderung verschiedener Verfahrensparameter steuerbar ist. Neben den allgemeingültigen Vorteilen, die sich bei der Verwendung von Plasmastrahlung als Werkzeug ergeben, die ebenfalls in der kontaktlosen Bearbeitung eines Werkstückes und damit in der Verschleißfreiheit des Werkzeuges liegen, ist es von Vorteil, dass die Werkzeugbreite gut steuerbar ist. In beiden Fällen lässt sich die Wirkung des Werkzeuges über die Steuerung von Verfahrensparametern gezielt steuern, weshalb über eine wiederholte zwischenzeitliche Prüfung des Bearbeitungsergebnisses während der Bearbeitung eines Werkstückes und eine daraus abgeleitete Änderung von Steuergrößen der temporäre Ist-Bearbeitungszustand immer wieder an den temporären Soll-Bearbeitungszustand angepasst werden muss. In beiden Fällen verflüchtigt sich ein eventueller Materialabtrag, weshalb eine örtliche Prüfung mit einer optischen Prüfeinheit unmittelbar nach der Bearbeitung möglich ist.

Die Prüfeinheit 4 weist eine Prüfstrahlquelle 4.1, die einen Prüfstrahl P aussendet und direkt oder über eine Abstrahleinheit, mit einer strahlformenden Optik, auf den Werkstückträger 2 richtet, sowie einen Detektor 4.2, der einen an dem Werkstück 1 transmittierten, reflektierten oder gestreuten Prüfstrahlanteil P' des Prüfstrahles P detektiert, auf.

Die Bearbeitungseinheit 3 und die Prüfeinheit 4 sind aufeinander abgestimmt gemeinsam mittels eines oder mittels jeweils eines Linearmotors 6 gegenüber dem Werkstückträger 2 synchron linear bewegbar, so dass die Bearbeitungseinheit 3 und die Prüfeinheit 4 mit einem Zeitversatz, der durch den örtlichen Versatz zwischen der Bearbeitungseinheit 3 und der Prüfeinheit 4 um einen Winkelabstand βₙ und die Drehgeschwindigkeit ω des Werkstückträgers 2 bestimmt ist, ein selbes Werkstück 1 entlang nebeneinander verlaufender Scanlinien in gleicher Weise abscannen, wobei das Werkstück 1 entlang der Scanlinien bearbeitet und geprüft wird. Unter einem Linearmotor 6 wird im Sinne dieser Beschreibung jeder Antrieb verstanden, der ein translatorische Bewegung in eine konstante Richtung mit einem sich ändernden Richtungssinn ermöglicht.

Zusätzlich kann ein ergänzender Detektor 4.2, z. B. ein Spektrometer, vorhanden sein, der am Bearbeitungsort emittierende Strahlung detektiert.

Es ist erfindungswesentlich, dass die Bearbeitungseinheit 3 und die Prüfeinheit 4, genau genommen deren Mittenachsen, einen vom Versatz bestimmten Winkelabstand βₙ miteinander einschließend, jeweils radial zur Drehachse 2.0 justierbar angeordnet und in zwei radiale translatorische Richtungen R_{trans 1}, R_{trans 2} mit wechselndem Richtungssinn Translationsbewegungen ausführend angetrieben werden. Bei einer gleichzeitigen Ansteuerung des Motors 5 und des wenigstens einen Linearmotors 6 beschreiben der Bearbeitungsstrahl E und der Prüfstrahl P eine selbe spiralförmige Bewegungsbahn S um die Drehachse 2.0 des Werkstückträgers 2, sind jedoch zu einem selben Zeitpunkt jeweils auf unterschiedliche Orte der Bewegungsbahn S gerichtet. Das heißt, ein Ort, in dem der Bearbeitungsstrahl E auftrifft, wird nach einer bekannten Zeitdauer von dem Prüfstahl P beaufschlagt. Dabei treffen jeweils der Bearbeitungsstrahl E in einem Auftreffpunkt P_{E} und der Prüfstrahl P in einem Prüfpunkt Pp auf. Der Auftreffpunkt P_{E} und der Prüfpunkt Pp weisen jeweils ein flächige Ausdehnung auf, die durch den jeweiligen Querschnitt des Bearbeitungsstrahls E bzw. des Prüfstrahls P beim Auftreffen auf die Oberfläche des Werkstückes 1 bestimmt ist. Die spiralförmige Bewegungsbahn S stellt bevorzugt eine archimedische Spirale dar, bei der benachbarte Windungen W, die jeweils einen um 360° umlaufenden Abschnitt der Spirale darstellen, einen konstanten Abstand zueinander aufweisen. Dazu wird bevorzugt die Drehgeschwindigkeit ω abhängig vom zunehmenden Abstand der Auftreffpunkte P_{E} zur Drehachse 2.0 an die zunehmende Länge der Windungen W angepasst. Vorteilhaft kann die spiralförmige Bewegungsbahn S von einer Schwingung überlagert sein, was ebenso wie die Umkehrung der Drehrichtung R_{dreh} zur Vermeidung der Entstehung von gerichteten Oberflächenstrukturen dient.

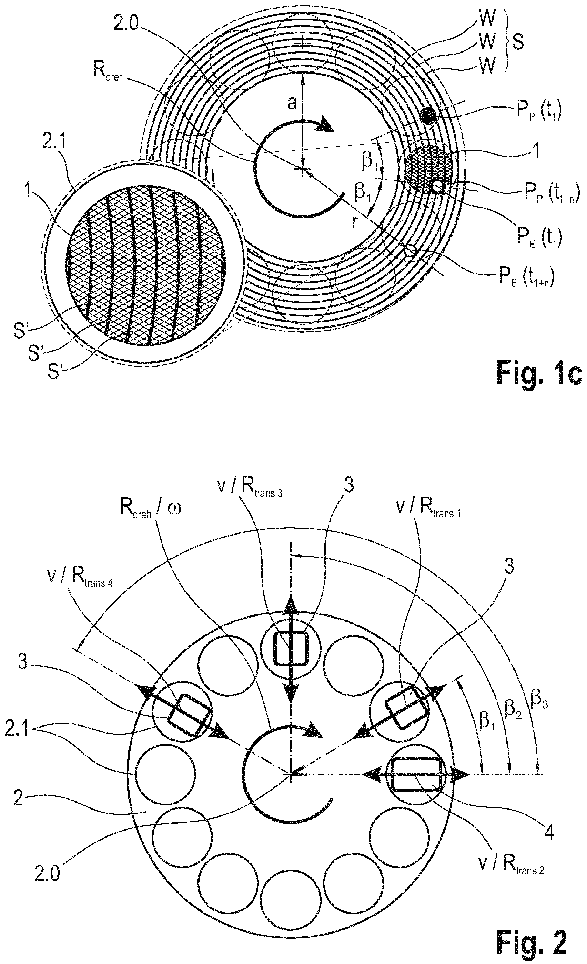

Es ist des Weiteren erfindungswesentlich, dass die Werkstückaufnahme 2.1 zu der Drehachse 2.0 in einem Abstand a entfernt angeordnet ist. Dadurch wird, wie in **Fig. 1c** schematisch gezeigt, die wenigstens eine Werkstückaufnahme 2.1 bzw. ein darin positioniertes Werkstück 1 nur von Teilabschnitten S' der Windungen W der Bewegungsbahn S überdeckt, die jeweils eine der Scanlinien darstellen.

Die Steuer- und Recheneinheit 7 steht mit der wenigstens einen Prüfeinheit 4, mit der wenigstens einen Bearbeitungseinheit 3, dem Motor 5 und dem wenigstens einen Linearmotor 6 in Verbindung und kann so in Abhängigkeit von aus dem detektierten Prüfstrahlanteil P' abgeleiteten Prüfergebnissen wenigstens einen Verfahrensparameter der Vorrichtung ändern und den Bearbeitungsstrahl E und den Prüfstrahl P ein- und ausschalten.

Vorteilhaft sind auf dem Werkstückträger 2 so viele Werkstückaufnahmen 2.1 vorhanden, wie sie Platz haben, um innerhalb eines Bearbeitungszyklus so viele Werkstücke 1 wie möglich bearbeiten zu können. Sollen die Werkstücke 1 innerhalb des Bearbeitungszyklus mit Bearbeitungsstrahlen E verschiedener Bearbeitungsstrahlquellen 3.1 bearbeitet werden, z.B. erst mit einem Ultrakurzpulslaserstrahl und abschließend mit einem Plasmastrahl, werden entsprechend zwei Bearbeitungseinheiten 3 angeordnet. Es können jedoch vorteilhaft auch mehrere Bearbeitungseinheiten 3 gleicher Art angeordnet werden, was zu einer Verkürzung der Zyklusdauer führt. In **Fig. 2** ist beispielhaft eine Vorrichtung mit einer Prüfeinheit 4 und drei Bearbeitungseinheiten 3 gezeigt, die jeweils einen bekannten Winkelabstand βₙ mit der Prüfeinheit 4 einschließen. Bevorzugt sind die Winkelabstände βₙ einstellbar, womit der zeitliche Abstand zwischen der Bearbeitung durch zwei Bearbeitungsstrahlen E beeinflusst werden kann, z.B. um eine zwischenzeitliche Abkühlung zu vermeiden oder zu fördern. Mehrere Prüfeinheiten 4 ermöglichen eine genauere Steuerung der Prozessparameter.
So wie eine durch die Größe der Werkstücke 1 begrenzte Anzahl von Werkstückaufnahmen 2.1 auf dem Werkstückträger 2 ausgeschöpft werden kann, kann auch die durch den Raumbedarf der Bearbeitungseinheiten 3 begrenzte Anzahl der Bearbeitungseinheiten 3 für eine Vorrichtung ausgeschöpft werden.
Da die Bearbeitung bzw. die Prüfung eines Werkstückes 1 unabhängig voneinander jeweils genau dann passiert, wenn eines der Werkstücke 1 unter dem Bearbeitungsstrahl E bzw. dem Prüfstrahl P durchgedreht wird, kann die Vorrichtung grundsätzlich mit einer durch den Platzbedarf beschränkten größten Anzahl von Werkstückaufnahmen 2.1, Bearbeitungseinheiten 3 und Prüfeinheiten 4 ausgestattet sein. Da die Drehbewegung für alle Bearbeitungs- und Prüfeinheiten 3, 4 durch denselben Werkstückträger 2 erfolgt, bedingt dies nur noch eine synchrone translatorische Bewegung der Bearbeitungs- und Prüfeinheiten 3, 4.

Um Werkstücke 1 mit dreidimensionaler Oberfläche bearbeiten und prüfen zu können, ist pro Bearbeitungseinheit 3 und pro Prüfeinheit 4 jeweils eine ebenfalls mit der Steuer- und Recheinheit 7 verbundene Kippeinheit 8.3, 8.4 vorhanden, die bevorzugt zwei senkrecht zueinander angeordnete Kippachsen aufweist. Damit können die Bearbeitungs- bzw. die Prüfeinheiten 3, 4 in ihrer Raumlage relativ zum Werkstückträger 2 verkippt und so ausgerichtet werden, dass sie auf die Oberflächen der Werkstücke 1 in einem vorgegebenen Auftreffwinkel auftreffen. Dabei wird zumindest der Bearbeitungsstrahl E senkrecht auf die Oberfläche gerichtet. Für den Prüfstrahl P gilt, dass er zum Flächenlot auf die Oberfläche stets in einer gleichen Raumwinkellage gerichtet wird, um gleiche Messverhältnisse zu haben.

Nachfolgend wird ein erfindungsgemäßes Verfahren in seiner Allgemeingültigkeit und vorteilhaften Ausgestaltungen beschrieben.
Gleich einem aus dem Stand der Technik bekannten Verfahren wird wenigstens ein Werkstück 1 in einer Werkstückaufnahme 2.1 auf einem Werkstückträger 2 positioniert und entlang nebeneinander verlaufender Scanlinien mit einem Bearbeitungsstrahl E abgetastet, wobei es bearbeitet wird, und mit einem Prüfstrahl P abgetastet, wobei Messungen durchgeführt werden, indem aus einem am Werkstück 1 transmittierten, reflektierten oder gestreuten Prüfstrahlanteil P' des Prüfstrahls P jeweils auf die Oberfläche des Werkstücks 1 ortsbezogene Prüfergebnisse abgeleitet werden, aus denen Rückschlüsse auf die Auswirkung der Einwirkung des Bearbeitungsstrahls E auf das Werkstück 1 gezogen werden.

Es ist erfindungswesentlich, dass das Werkstück 1 dabei um eine außerhalb des Werkstückes 1 liegende Drehachse 2.0 des Werkstückträgers 2 eine Drehbewegung mit einer Drehgeschwindigkeit ω ausführt und zeitgleich der Bearbeitungsstrahl E und der Prüfstrahl P jeweils mit einer Vorschubgeschwindigkeit v in zwei einen Winkelabstand βₙ miteinander einschließende translatorische Richtungen R_{trans 1}, R_{trans 2}, radial zur Drehachse 2.0 Translationsbewegungen ausführen. Durch die Überlagerung der Drehbewegung mit einer der Translationsbewegungen beschreiben der Bearbeitungsstrahl E und der Prüfstrahl P jeweils eine selbe spiralförmige Bewegungsbahn S mit einer Vielzahl von Windungen W relativ zu dem Werkzeugträger 2. Die Scanlinien werden dabei von Teilabschnitten S' der Windungen W gebildet, die jeweils die Werkstückaufnahme 2.1 überdecken, in der eines der Werkstücke 1 positioniert ist. In Abhängigkeit vom Abstand der Scanlinien, der über das Verhältnis der Drehgeschwindigkeit ω zur Vorschubgeschwindigkeit v eingestellt wird, und von den Parametern des Bearbeitungsstrahls E, die für die Breite der entstehenden Bearbeitungsspur entlang der Scanlinien bestimmend sind, werden sich überlappende, aneinander grenzende oder voneinander beabstandete Bearbeitungsspuren erzeugt. Die Bearbeitungsspuren selbst werden durch aneinandergrenzende bzw. in der Regel sich überlappende Auftreffpunkte des Bearbeitungsstrahls E gebildet, die in der Regel einen gleichen oder kleineren Querschnitt aufweisen als die Prüfpunkte Pp, die durch den Querschnitt des auftreffenden Prüfstrahls P bestimmt werden. Den auf den Werkstückträger 2 und damit den Werkstücken 1 ortsbezogenen Prüfpunkten P_{P} können dann gegebenenfalls mehrere Auftreffpunkte P_{E} des Bearbeitungsstrahls E entlang einer Scanlinie oder auch einer benachbarten Scanlinie zugeordnet werden. Die Prüfergebnisse jeweils einer Messung, die jeweils aus einem an einem Prüfpunkt P_{P} transmittierten, reflektierten oder gestreuten Prüfstrahlanteil P' gewonnen werden, werden als ortsbezogene Istwerte jeweils einer Steuer- und Recheneinheit 7 zugeführt. Dort werden sie abgespeicherten ortsbezogenen Sollwerten zugeordnet und mit diesen verglichen. Bei einer Abweichung eines der Sollwerte von dem zugeordneten Istwert wird wenigstens ein Verfahrensparameter geändert, wenn der Bearbeitungsstrahl E nachfolgend in einem Auftreffpunkt P_{E} innerhalb des betreffenden Prüfpunktes Pp auf das Werkstück 1 auftrifft, an dem zuvor die die Änderung begründenden ortsbezogenen Istwerte gewonnen wurden. Die Änderung von Verfahrensparametern in Abhängigkeit von temporären Bearbeitungsergebnissen während der Bearbeitung führt zu einem geregelten Bearbeitungsprozess.

Ein veränderbarer Verfahrensparameter ist z. B. die Einwirkdauer des Bearbeitungsstrahls E an einem Auftreffpunkt P_{E}. Sie kann über die Steuerung der Drehgeschwindigkeit ω beeinflusst werden. Davon unabhängig muss die Drehgeschwindigkeit ω in Abhängigkeit vom radialen Abstand r eines Auftreffpunktes P_{E} des Bearbeitungsstrahls E gesteuert werden, um eine konstante Einwirkdauer des Bearbeitungsstrahls E entlang der Scanlinien zu erreichen. Andere steuerbare Verfahrensparameter sind z.B. die Abstrahlleistung der betreffenden Bearbeitungsstrahlquelle, die Pulsfrequenz und die Pulsdichte des Bearbeitungsstrahls 3.1, die Querschnittsgröße des Auftreffpunktes P_{E}, die z.B. über eine Fokussierung bzw. noch genauer über eine Fokusnachführung steuerbar ist, und die Relativgeschwindigkeit des Bearbeitungsstrahls E relativ zum Werkstückträger 2.

Vorteilhaft kann über die Einstellung des Verhältnisses zwischen der Drehgeschwindigkeit ω und der Vorschubgeschwindigkeit v die Steigung der spiralförmigen Bewegungsbahn S und damit der Abstand der Scanlinien eingestellt werden. Damit kann insbesondere der Grad einer Überlappung der entstehenden Bearbeitungsspuren eingestellt werden.

Die Änderung des wenigstens einen Verfahrensparameters erfolgt dann, wenn der Bearbeitungsstrahl E an einem Ort auf das Werkstück 1 gerichtet wird, an dem zuvor die die Änderung begründenden ortsbezogenen Istwerte gewonnen wurden.
Das kann innerhalb eines nachfolgenden Scanzyklus erfolgen, oder aber, wenn die Prüfpunkte Pp jeweils eine größere Ausdehnung aufweisen als die Auftreffpunkte P_{E} innerhalb des gleichen Scanzyklus beim Scannen einer nächsten Scanlinie.

In **Fig. 1c** sind für einen beispielhaften ersten Zeitpunkt t₁, nach einigen Umdrehungen während eines Scanzyklus, die Position eines Auftreffpunktes P_{E} und eines Prüfpunktes P_{P} auf der Bewegungsbahn S dargestellt. Der Auftreffpunkt P_{E} liegt auf dem hier dargestellten Werkstück 1 und die fett gezeichneten Scanlinien, welche Teilabschnitte S' der Bewegungsbahn S darstellen, sind bereits in diesem Scanzyklus bearbeitet worden. Der Prüfpunkt P_{P} läuft dem Auftreffpunkt P_{E} in Drehrichtung R_{dreh} mit einem Winkelabstand β₁ nach und befindet sich zum ersten Zeitpunkt t₁ hinter dem Werkstück 1.
Zu einem späteren Zeitpunkt t₁₊ₙ befindet sich der Prüfpunkt P_{P} auf dem Werkstück 1 und der Auftreffpunkt P_{E} befindet sich vor dem Werkstück 1. In Kenntnis der Relativlage und der Ausrichtung der Prüfeinheit 4 zur Bearbeitungseinheit 3 und zum Werkstückträger 2 sowie in Kenntnis der Raumlage und Ausrichtung des Werkstückes 1 zum Werkstückträger 2 können die aus dem Prüfpunkt P_{P} zum Zeitpunkt t₁ abgeleiteten Messergebnisse im gleichen Scanzyklus oder in dem darauffolgenden Scanzyklus einem Ort auf dem Werkstück 1 zugeordnet werden, indem der Bearbeitungsstrahl E wenigstens in einem Auftreffpunkt P_{E} auftrifft. So können die aus den ortbezogenen Messergebnissen im Vergleich mit Sollergebnissen abgeleiteten Abweichungen genutzt werden, um Verfahrensparameter genau dann zu ändern, wenn der Bearbeitungsstrahl E auf einen Ort auf dem Werkstück 1 auftrifft, an dem aus einem Prüfpunkt P_{P} diesem Ort zugeordnete Abweichungen abgeleitet wurden, womit der Bearbeitungsprozess verzögert geregelt wird.

Indem die Vorrichtung mehrere Bearbeitungseinheiten 3 aufweist, können während einer Umdrehung sämtliche auf dem Werkstückträger 2 angeordnete Werkstücke 1 mit mehr als einem Bearbeitungsstrahl E bearbeitet werden.

Analog kann das Werkstück 1 während einer Umdrehung des Werkstückträgers 2 mit mehr als einem Prüfstrahl P geprüft werden, wenn die Vorrichtung mehrere Prüfeinheiten 4 aufweist.

Und es können mehrere Werkstücke 1 in einem Zyklus parallel bearbeitet und geprüft werden, indem sie für einen gleichen Bearbeitungszeitraum auf dem Werkstückträger 2 positioniert werden.

Es kann von Vorteil sein, während des Verfahrens die Drehrichtung R_{dreh} umzukehren. Dadurch bilden sich geringfügig unterschiedliche Bewegungsbahnen S aus, was dem Entstehen gerichteter Strukturen auf der Oberfläche entgegenwirkt.

Die Vorrichtung und das Verfahren sind besonders vorteilhaft, wenn als Bearbeitungsstrahlquelle 3.1 ein Ultrakurzpulslaser verwendet wird. Bekanntermaßen erfolgt ein Materialabtrag mittels eines solchen Lasers, indem pro Puls pro Auftreffpunkt P_{E} eine winzige Materialmenge vaporisiert wird, sodass der gewünschte Gesamtabtrag erst durch ein mehrfaches Scannen der zu bearbeitenden Oberfläche erfolgt. Das heißt, jeder Ort der Oberfläche des zu bearbeitenden Werkstücks 1 wird mehrfach in mehreren Scanzyklen mit der Laserstrahlung beaufschlagt. Es erfolgt eine Überwachung und Steuerung von Prozessparametern, sodass der Ist-Abtrag pro Scanzyklus immer wieder dem Sollabtrag in diesem Scanzyklus angenähert wird, wodurch ein sehr genaues Bearbeitungsergebnis erreicht wird, was sich in einer exakten reproduzierbaren Oberflächengeometrie und/oder einer Oberflächengüte ausdrückt.

### Bezugszeichenliste

- 1: Werkstück
- 2: Werkstückträger
- 2.0: Drehachse
- 2.1: Werkstückaufnahme
- 3: Bearbeitungseinheit
- 3.1: Bearbeitungsstrahlquelle
- 4: Prüfeinheit
- 4.1: Prüfstrahlquelle
- 4.2: Detektor
- 5: Motor
- 6: Linearmotor
- 7: Steuer- und Recheneinheit
- 8.3: Kippeinheit der Bearbeitungseinheit 3
- 8.4: Kippeinheit der Prüfeinheit 4
- E: Bearbeitungsstrahl
- P: Prüfstrahl
- P': Prüfstrahlanteil
- R_{dreh}: Drehrichtung
- R_{trans n}: translatorische Richtungen
- ω: Drehgeschwindigkeit
- v: Vorschubgeschwindigkeit
- α: Drehwinkel
- βₙ: Winkelabstand
- a: Abstand des Werkstückträgers 2 zur Drehachse 2.0
- r: radialer Abstand des Auftreffpunktes P_{E}
- P_{E}: Auftreffpunkt des Bearbeitungsstrahls E
- P_{P}: Prüfpunkt
- S: Bewegungsbahn
- S': Teilabschnitt der Windungen W der Bewegungsbahn S
- W: Windungen der Bewegungsbahn S

## Patentansprüche

1. Vorrichtung zum geregelten Bearbeiten wenigstens eines Werkstückes (1) mit einer Bearbeitungsstrahlung mit
einem Werkstückträger (2), der wenigstens eine Werkstückaufnahme (2.1), zur Aufnahme des wenigstens einen Werkstückes (1) aufweist, wenigstens einer Bearbeitungseinheit (3) mit einer Bearbeitungsstrahlquelle (3.1), die einen Bearbeitungsstrahl (E) auf das in der wenigstens einen Werkstückaufnahme (2.1) aufgenommene Werkstück (1) richtet, wenigstens einer Prüfeinheit (4) mit einer Prüfstrahlquelle (4.1), die einen Prüfstrahl (P) auf das in der wenigstens einen Werkstückaufnahme (2.1) aufgenommene Werkstück (1) richtet, und einem Detektor (4.2), der einen transmittierten, reflektierten oder gestreuten Prüfstrahlanteil (P') des Prüfstrahles (P) detektiert, und wenigstens einem Linearmotor (6), mit dem die wenigstens eine Bearbeitungseinheit (3) und die wenigstens eine Prüfeinheit (4) relativ zum Werkstückträger (2) beweglich sind, wobei das in der wenigstens einen Werkstückaufnahme (2.1) positionierte Werkstück (1) entlang nebeneinander verlaufender Scanlinien durch den Bearbeitungsstrahl (E) und den Prüfstrahl (P) nachlaufend abgescannt wird und das Werkstück (1) entlang der Scanlinien bearbeitet und geprüft wird, **dadurch gekennzeichnet,**
**dass** ein Motor (5) vorhanden ist und der Werkstückträger (2) eine umlaufende Drehachse (2.0) aufweist, die zur Erzeugung einer Drehbewegung des Werkstückträgers (2) in einer Drehrichtung (R_{dreh}) mit dem Motor (5) verbunden ist, dass die wenigstens eine Bearbeitungseinheit (3) und die wenigstens eine Prüfeinheit (4) gegenüber der Drehachse (2.0) um einen Winkelabstand (βₙ) zueinander versetzt jeweils radial zur Drehachse (2.0) justierbar angeordnet und mit dem wenigstens einen Linearmotor (6) verbunden sind, zur Erzeugung von Translationsbewegungen der Bearbeitungseinheit (3) und der Prüfeinheit (4) gegenüber dem Werkstückträger (2) in zwei den Winkelabstand (βₙ) miteinander einschließende radiale translatorische Richtungen (R_{trans 1}, R_{trans 2}),
wodurch bei gleichzeitiger Ansteuerung des Motors (5) und des wenigstens einen Linearmotors (6) der Bearbeitungsstrahl (E) und der Prüfstrahl (P) um den Winkelabstand (βₙ) zueinander versetzt relativ zum Werkstückträger (2) eine selbe spiralförmige Bewegungsbahn (S) mit einer Vielzahl von Windungen (W) beschreiben,
**dass** die wenigstens eine Werkstückaufnahme (2.1) zu der Drehachse (2.0) in einem Abstand (a) entfernt angeordnet ist, sodass die wenigstens eine Werkstückaufnahme (2.1) oder ein darin positioniertes Werkstück (1) von Teilabschnitten (S') der Windungen (W) überdeckt wird, die jeweils eine der Scanlinien darstellen, und
**dass** eine Steuer- und Recheneinheit (7) vorhanden ist, die mit der wenigstens einen Prüfeinheit (4), mit der wenigstens einen Bearbeitungseinheit (3), dem Motor (5) und dem wenigstens einen Linearmotor (6) in Verbindung steht, um in Abhängigkeit von aus dem detektierten Prüfstrahlanteil (P') abgeleiteten Prüfergebnissen wenigstens einen Verfahrensparameter der Vorrichtung zu ändern.

2. Vorrichtung nach Anspruch 1, **dadurch gekennzeichnet,**
**dass** eine Summe von mehreren Bearbeitungseinheiten (3) vorhanden ist, die einen Kreis um die Drehachse (2.0) bildend angeordnet sind und die Summe größer der Anzahl der Werkstückaufnahmen (2.1) ist.

3. Vorrichtung nach Anspruch 2, **dadurch gekennzeichnet,**
**dass** wenigstens eine erste Kippeinheit (8.3) vorhanden ist, die mit der wenigstens einen Bearbeitungseinheit (3) verbunden ist, und wenigstens eine zweite Kippeinheit (8.4) vorhanden ist, die mit der wenigstens einen Prüfeinheit (4) verbunden ist, womit die Ausrichtung des Bearbeitungsstrahles (E) und des Prüfstrahles (P) zu einer Oberfläche des in der mindestens einen Werkstückaufnahme (2.1) positionierten Werkstückes (1) veränderbar ist.

4. Vorrichtung nach Anspruch 1, **dadurch gekennzeichnet,**
**dass** die Bearbeitungsstrahlquelle (3.1) der mindestens einen Bearbeitungseinheit (3) ein Laser oder eine Plasma-Strahlquelle ist.

5. Verfahren zum Bearbeiten wenigstens eines Werkstückes (1) mit einer Bearbeitungsstrahlung,
bei dem das wenigstens eine Werkstück (1) in einer Werkstückaufnahme (2.1) auf einem Werkstückträger (2) positioniert wird und entlang nebeneinander verlaufender Scanlinien mit einem Bearbeitungsstrahl (E) mehrfach jeweils in einem Scanzyklus abgetastet wird, wobei das Werkstück (1) bearbeitet wird, und während der Scanzyklen mit einem dem Bearbeitungsstrahl (E) nachlaufenden Prüfstrahl (P) abgetastet wird, wobei Messungen durchgeführt werden, bei denen aus transmittierten, reflektierten oder gestreuten Prüfstrahlanteilen (P') des jeweils in ausgedehnten Prüfpunkten (P_{P}) auf eines der Werkstücke (1) auftreffenden Prüfstrahls (P) ortsbezogene Prüfergebnisse abgeleitet werden, aus denen Rückschlüsse auf die Auswirkung der lokalen Einwirkung des Bearbeitungsstrahls (E) auf das jeweilige Werkstück (1) gezogen werden, **dadurch gekennzeichnet, dass** das Werkstück (1) um eine außerhalb des Werkstückes (1) liegende Drehachse (2.0) des Werkstückträgers (2) eine Drehbewegung in einer Drehrichtung (R_{dreh}) mit einer Drehgeschwindigkeit (ω) ausführt und zeitgleich der Bearbeitungsstrahl (E) und der Prüfstrahl (P) mit einer gleichen Vorschubgeschwindigkeit (v) in zwei einen Winkelabstand (βₙ) miteinander einschließende translatorische Richtungen (R_{trans 1}, R_{trans 2}) radial zur Drehachse (2.0) Translationsbewegungen ausführen, sodass der Bearbeitungsstrahl (E) und der Prüfstrahl (P) jeweils durch die Überlagerung der Drehbewegung mit einer der Translationsbewegungen über mehrere Umdrehungen des Werkstückträgers (2) jeweils eine selbe spiralförmige Bewegungsbahn (S) mit mehreren Windungen (W) um die Drehachse (2.0) relativ zu dem Werkzeugträger (2) beschreiben, wobei jeweils ein Teilabschnitt (S') einer der Windungen (W), die die Werkstückaufnahme (2.1) überdecken, eine der Scanlinien bildet, und
dass die Prüfergebnisse jeweils als auf einen der Prüfpunkte (P_{P}) ortsbezogene Istwerte einer Steuer- und Recheneinheit (7) zugeführt werden, wo sie abgespeicherten, auf das Werkstück (1) ortsbezogenen Sollwerten zugeordnet und mit diesen verglichen werden und bei einer Abweichung eines der Sollwerte von dem zugeordneten Istwert wenigstens ein Verfahrensparameter geändert wird, wenn der Bearbeitungsstrahl (E) nachfolgend in einem Auftreffpunkt (P_{E}) innerhalb des betreffenden Prüfpunktes (Pp) auf das Werkstück (1) auftrifft, an dem zuvor die die Änderung begründenden ortsbezogenen Istwerte gewonnen wurden.

6. Verfahren nach Anspruch 5, **dadurch gekennzeichnet,**
**dass** die Prüfpunkte (P_{P}) jeweils eine größere Ausdehnung aufweisen als die Auftreffpunkte (P_{E}) und die Änderung der Verfahrensparameter innerhalb des gleichen Scanzyklus erfolgt.

7. Verfahren nach Anspruch 5, **dadurch gekennzeichnet,**
**dass** die Änderung der Verfahrensparameter innerhalb eines nachfolgenden Scanzyklus erfolgt.

8. Verfahren nach Anspruch 5, **dadurch gekennzeichnet,**
**dass** die Drehgeschwindigkeit (ω) in Abhängigkeit vom radialen Abstand (r) des Auftreffpunktes (P_{E}) des Bearbeitungsstrahls (E) gesteuert wird, um eine konstante Einwirkdauer des Bearbeitungsstrahls (E) entlang der Scanlinien zu erreichen.

9. Verfahren nach Anspruch 5, **dadurch gekennzeichnet,**
**dass** über die Einstellung des Verhältnisses zwischen der Drehgeschwindigkeit (ω) und der Vorschubgeschwindigkeit (v) die Steigung der spiralförmigen Bewegungsbahn (S) und damit der Abstand der Scanlinien eingestellt wird.

10. Verfahren nach Anspruch 5, **dadurch gekennzeichnet,**
**dass** die Drehrichtung (R_{dreh}) während des Verfahrens umgekehrt wird.

11. Verfahren nach Anspruch 5, **dadurch gekennzeichnet,**
**dass** das Werkstück (1) während einer Umdrehung des Werkstückträgers (2) mit mehr als einem Bearbeitungsstrahl (E) bearbeitet wird.

12. Verfahren nach Anspruch 11, **dadurch gekennzeichnet,**
**dass** das Werkstück (1) während einer Umdrehung des Werkstückträgers (2) mit mehr als einem Prüfstrahl (P) geprüft wird.

13. Verfahren nach Anspruch 8, 11 oder 12, **dadurch gekennzeichnet,**
**dass** mehrere Werkstücke (1) in denselben Scanzyklen bearbeitet und geprüft werden, indem sie für einen gleichen Bearbeitungszeitraum auf dem Werkstückträger (2) positioniert werden.

## Claims

1. A device for the controlled processing of at least one workpiece (1) with processing radiation, comprising
a workpiece carrier (2) which has at least one workpiece receptacle (2.1) for receiving the at least one workpiece (1), at least one processing unit (3) having a processing beam source (3.1) which directs a processing beam (E) onto the workpiece (1) received in the at least one workpiece receptacle (2.1), at least one inspection unit (4) having an inspection beam source (4.1) which directs an inspection beam (P) onto the workpiece (1) received in the at least one workpiece receptacle (2.1), and a detector (4.2), which detects a transmitted, reflected or scattered inspection beam portion (P') of the inspection beam (P), and at least one linear motor (6), by which the at least one processing unit (3) and the at least one inspection unit (4) can be moved relative to the workpiece carrier (2), wherein the workpiece (1) positioned in the at least one workpiece receptacle (2.1) is scanned by the processing beam (E) and the inspection beam (P), following the processing beam (E), along scan lines extending side by side, and the workpiece (1) is processed and inspected along the scan lines, **characterised in that** a motor (5) is present and the workpiece carrier (2) has a revolving rotary shaft (2.0) which is connected to the motor (5) in order to generate a rotary motion of the workpiece carrier (2) in a direction of rotation (R_{dreh}), the at least one processing unit (3) and the at least one inspection unit (4), offset by an angular distance (βₙ) relative to one another with respect to the rotary shaft (2.0), are arranged so as to be radially adjustable relative to the rotary shaft (2.0) and are connected to the at least one linear motor (6) in order to generate translational movements of the processing unit (3) and of the inspection unit (4) relative to the workpiece carrier (2) in two radial translational directions (R_{trans 1}, R_{trans 2}) which enclose the angular distance (βₙ) with one another, whereby, when the motor (5) and the at least one linear motor (6) are controlled simultaneously, the processing beam (E) and the inspection beam (P), offset from one another by the angular distance (βₙ) describe the same spiral movement path (S) with a plurality of turnings (W) relative to the workpiece carrier (2),
the at least one workpiece receptacle (2.1) is arranged at a distance (a) from the rotary shaft (2.0) so that the at least one workpiece receptacle (2.1) or a workpiece (1) positioned therein is covered by partial sections (S') of the turnings (W) which each represent one of the scan lines, and
a control and computing unit (7) is present, which is connected to the at least one inspection unit (4), to the at least one processing unit (3), to the motor (5) and to the at least one linear motor (6) in order to change at least one process parameter of the device as a function of inspection results derived from the detected inspection beam portion (P)'.

2. The device according to claim 1, **characterised in that**
there is a sum of several processing units (3) which are arranged to form a circle around the rotary shaft (2.0) and the sum is greater than the number of workpiece receptacles (2.1).

3. The device according to claim 2, **characterised in that**
at least one first tilting unit (8.3) is present which is connected to the at least one processing unit (3), and at least one second tilting unit (8.4) is present which is connected to the at least one inspection unit (4), thus allowing the orientation of the processing beam (E) and of the inspection beam (P) to be changed with respect to a surface of the workpiece (1) positioned in the at least one workpiece receptacle (2.1).

4. The device according to claim 1, **characterised in that**
the processing beam source (3.1) of the at least one processing unit (3) is a laser or a plasma beam source.

5. A method for processing at least one workpiece (1) with processing radiation,
wherein the at least one workpiece (1) is positioned in a workpiece receptacle (2.1) on a workpiece carrier (2) and is scanned several times in each case in one scanning cycle by a processing beam (E) along scan lines extending side by side, wherein the workpiece (1) is processed and is scanned during the scanning cycles by an inspection beam (P) following the processing beam (E), wherein measurements are carried out in which location-related inspection results are derived from transmitted, reflected or scattered inspection beam portions (P') of the inspection beam (P) impinging on one of the workpieces (1) at extended inspection points (P_{P}) in each case, from which inspection results conclusions are drawn as to the effect of the local action of the processing beam (E) on the respective workpiece (1), **characterised in that** the workpiece (1) executes a rotary motion in a direction of rotation (R_{dreh}) at a rotational speed (ω) about a rotary shaft (2.0) of the workpiece carrier (2), said rotary shaft (2.0) lying outside the workpiece (1), and at the same time the processing beam (E) and the inspection beam (P) execute translational movements radially to the rotary shaft (2.0), at the same feed rate (v) in two translational directions (R_{trans 1}, R_{trans 2}), which enclose an angular distance (βₙ) with one another, so that the processing beam (E) and the inspection beam (P) each describe, by the superposition of the rotary motion with one of the translational movements over a plurality of revolutions of the workpiece carrier (2), a respective identical spiral-shaped movement path (S) with a plurality of windings (W) about the rotary shaft (2.0) relative to the workpiece carrier (2), wherein in each case a partial section (S') of one of the windings (W), which cover the workpiece receptacle (2.1), forms one of the scan lines, and
the inspection results are respectively supplied, as actual values which are location-related to one of the inspection points (P_{P}), to a control and computing unit (7) where they are assigned to stored target values which are location-related to the workpiece (1) and are compared with these and, in the event of a deviation of one of the target values from the assigned actual value, at least one process parameter is changed if the processing beam (E) subsequently impinges on the workpiece (1) at a point of incidence (P_{E}) within the relevant inspection point (P_{P}) at which the location-related actual values on which the change is based were previously obtained.

6. The method according to claim 5, **characterised in that**
the inspection points (P_{P}) each have a larger extension than the points of incidence (P_{E}) and the change in process parameters occurs within the same scanning cycle.

7. The method according to claim 5, **characterised in that**
the change in process parameters occurs within a subsequent scanning cycle.

8. The method according to claim 5, **characterised in that**
the rotational speed (ω) is controlled as a function of the radial distance (r) of the point of incidence (P_{E}) of the processing beam (E) in order to achieve a constant exposure time of the processing beam (E) along the scan lines.

9. The method according to claim 5, **characterised in that**
the pitch of the spiral movement path (S) and thus the distance between the scan lines is set by setting the ratio between the rotation speed (ω) and the feed rate (v).

10. The method according to claim 5, **characterised in that**
the direction of rotation (R_{dreh}) is reversed during the process.

11. The method according to claim 5, **characterised in that**
the workpiece (1) is processed by more than one processing beam (E) during one revolution of the workpiece carrier (2).

12. The method according to claim 11, **characterised in that**
the workpiece (1) is inspected by more than one inspection beam (P) during one revolution of the workpiece carrier (2).

13. The method according to claim 8, 11 or 12, **characterised in that**
several workpieces (1) are processed and inspected in the same scanning cycles by positioning them on the workpiece carrier (2) for the same processing period.

## Revendications

1. Dispositif pour l'usinage contrôlé d'au moins une pièce (1) avec un rayonnement d'usinage, ledit dispositif comprenant
un porte-pièces (2) qui présente au moins un récepteur de pièces (2.1) pour maintenir la au moins une pièce (1), au moins une unité d'usinage (3) avec une source de faisceau d'usinage (3.1) qui dirige un faisceau d'usinage (E) sur la pièce maintenue dans ledit au moins un récepteur de pièces (2.1), au moins une unité d'inspection (4) avec une source de faisceau d'inspection (4.1) qui dirige un faisceau d'inspection (P) sur la pièce (1) logée dans ledit au moins un récepteur de pièces (2.1), et un détecteur (4. 2), qui détecte une composante de faisceau d'inspection (P') transmise, réfléchie ou diffusée du faisceau d'inspection (P), et au moins un moteur linéaire (6), au moyen duquel ladite au moins une unité d'usinage (3) et ladite au moins une unité d'inspection (4) sont mobiles par rapport au porte-pièces (2), où la pièce (1) positionnée dans ledit au moins un récepteur de pièces (2.1) est balayée par le faisceau d'usinage (E) et le faisceau d'inspection (P), qui suit le faisceau d'usinage (E), le long de lignes de balayage adjacentes et la pièce (1) est usinée et inspectée le long des lignes de balayage, **caractérisé en ce qu'**un moteur (5) est présent et le porte-pièces (2) présente un axe de rotation (2.0) tournant qui est relié au moteur (5) afin de produire un mouvement de rotation du porte-pièces (2) dans un sens de rotation (R_{dreh}), **en ce que** ladite au moins une unité d'usinage (3) et ladite au moins une unité d'inspection (4), décalées entre eux d'une distance angulaire (βₙ) par rapport à l'axe de rotation (2.0), sont chacune disposées de manière réglable radialement par rapport à l'axe de rotation (2.0) et sont reliées à l'au moins un moteur linéaire (6) afin de générer des mouvements de translation de l'unité d'usinage (3) et de l'unité d'inspection (4) par rapport au porte-pièces (2) dans deux directions de translation radiales (R_{trans 1}, R_{trans 2}) présentant la distance angulaire (βₙ) l'une par rapport à l'autre,
de sorte que, lorsque le moteur (5) et ledit au moins un moteur linéaire (6) sont commandés simultanément, le faisceau d'usinage (E) et le faisceau d'inspection (P), décalés l'un par rapport à l'autre de la distance angulaire (βₙ), décrivent la même trajectoire de mouvement en spirale (S) avec une pluralité de spires (W) par rapport au porte-pièces (2),
**en ce que** ledit au moins un récepteur de pièces (2.1) est disposé à une distance (a) de l'axe de rotation (2.0), de sorte que ledit au moins un récepteur de pièces (2.1) ou une pièce (1) positionnée dans celui-ci est recouvert par des sections partielles (S') des spires (W) qui représentent chacune une des lignes de balayage, et
**en ce qu'**il existe une unité de commande et de calcul (7) qui est reliée à l'au moins une unité d'inspection (4), à l'au moins une unité d'usinage (3), au moteur (5) et à l'au moins un moteur linéaire (6) afin de modifier au moins un paramètre de processus du dispositif en fonction des résultats d'inspection dérivés de la composante de faisceau d'inspection détectée (P').

2. Dispositif selon la revendication 1, **caractérisé en ce**
**qu'**il existe une somme de plusieurs unités d'usinage (3) qui sont disposées en formant un cercle autour de l'axe de rotation (2.0) et que la somme est supérieure au nombre de récepteurs de pièces (2.1).

3. Dispositif selon la revendication 2, **caractérisé en ce**
**qu'**il existe au moins une première unité de basculement (8.3), qui est reliée à ladite au moins une unité d'usinage (3), et au moins une deuxième unité de basculement (8.4), qui est reliée à ladite au moins une unité d'inspection (4), permettant de modifier l'alignement du faisceau d'usinage (E) et du faisceau d'inspection (P) par rapport à une surface de la pièce (1) positionnée dans l'au moins un récepteur de pièces (2.1).

4. Dispositif selon la revendication 1, **caractérisé en ce que**
la source de faisceau d'usinage (3.1) de ladite au moins une unité d'usinage (3) est un laser ou une source de faisceau plasma.

5. Dispositif pour l'usinage d'au moins une pièce (1) avec un rayonnement d'usinage,
dans lequel ladite au moins une pièce (1) est positionnée dans un récepteur de pièces (2.1) sur un porte-pièces (2) et est balayée le long de lignes de balayage adjacents avec un faisceau d'usinage (E) plusieurs fois respectivement en un cycle de balayage, la pièce (1) étant usinée, et est balayée pendant les cycles de balayage avec un faisceau d'inspection (P) qui suit le faisceau d'usinage (E), des mesures étant effectuées, lors desquelles des résultats d'inspection localisés sont déduits à partir de composantes (P') transmises, réfléchies ou diffusées du faisceau d'inspection (P), qui frappe respectivement l'une des pièces (1) en des points d'inspection étendus (Pp), ce qui permet de tirer des conclusions sur l'effet de l'influence locale du faisceau d'usinage (E) sur la pièce respective (1), **caractérisé en ce que**
la pièce (1) exécute un mouvement de rotation dans un sens de rotation (R_{dreh}) à une vitesse de rotation (ω) autour d'un axe de rotation (2.0) du porte-pièces (2) situé à l'extérieur de la pièce (1), et en même temps le faisceau d'usinage (E) et le faisceau d'inspection (P) exécutent des mouvements de translation radialement par rapport à l'axe de rotation (2.0) à une même vitesse d'avance (v) dans deux sens de translation (R_{trans 1}, R_{trans 2}) présentant une distance angulaire (βₙ) l'un par rapport à l'autre, de telle sorte que le faisceau d'usinage (E) et le faisceau d'inspection (P) décrivent chacun une même trajectoire de mouvement (S) en forme de spirale avec plusieurs spires (W) autour de l'axe de rotation (2.0) par rapport au porte-pièces (2) par la superposition du mouvement de rotation avec l'un des mouvements de translation sur plusieurs tours du porte-pièces (2), une section partielle (S') de l'une des spires (W) recouvrant le récepteur de pièces (2.1) formant à chaque fois l'une des lignes de balayage et **en ce que** les résultats d'inspection sont transmis, sous forme de valeurs réelles se rapportant à l'emplacement de l'un des points d'inspection (P_{P}), à une unité de commande et de calcul (7), où ils sont associés à des valeurs de consigne mémorisées se rapportant à l'emplacement de la pièce (1) et sont comparés à celles-ci et, en cas d'écart de l'une des valeurs de consigne par rapport à la valeur réelle associée, au moins un paramètre de processus est modifié,
si le faisceau d'usinage (E) frappe ensuite la pièce (1) en un point d'impact (P_{E}) situé à l'intérieur du point d'inspection pertinent (Pp) auquel les valeurs réelles liées à l'emplacement justifiant la modification ont été obtenues précédemment.

6. Procédé selon la revendication 5, **caractérisé en ce que**
les points d'inspection (P_{P}) ont chacun une extension plus grande que les points d'impact (P_{E}) et que la modification des paramètres du processus a lieu au cours du même cycle de balayage.

7. Procédé selon la revendication 5, **caractérisé en ce que**
la modification des paramètres du processus a lieu au cours d'un cycle de balayage ultérieur.

8. Procédé selon la revendication 5, **caractérisé en ce que**
la vitesse de rotation (ω) est contrôlée en fonction de la distance radiale (r) du point d'impact (P_{E}) du faisceau d'usinage (E) afin d'obtenir un temps d'exposition constant du faisceau d'usinage (E) le long des lignes de balayage.

9. Procédé selon la revendication 5, **caractérisé en ce que**
le pas de la trajectoire de mouvement en spirale (S) et donc la distance entre les lignes de balayage sont réglés en ajustant le rapport entre la vitesse de rotation (ω) et la vitesse d'avance (v).

10. Procédé selon la revendication 5, **caractérisé en ce que**
le sens de rotation (R_{dreh}) est inversé pendant le processus.

11. Procédé selon la revendication 5, **caractérisé en ce que**
la pièce (1) est usinée avec plus d'un faisceau d'usinage (E) pendant une révolution du porte-pièces (2).

12. Procédé selon la revendication 11, **caractérisé en ce que**
la pièce (1) est inspectée avec plus d'un faisceau d'inspection (P) pendant une révolution du porte-pièces (2).

13. Procédé selon la revendication 8, 11 ou 12, **caractérisé en ce que**
plusieurs pièces (1) sont usinées et inspectées dans les mêmes cycles de balayage en les positionnant sur le porte-pièces (2) pendant une même période d'usinage.
